# EUROPÄISCHE PATENTSCHRIFT

(11) **EP 3 984 247 B1**
(45) Veröffentlichungstag und Bekanntmachung des Hinweises auf die Patenterteilung: **30.09.2026**
(21) Anmeldenummer: 20730622.6
(22) Anmeldetag: 04.06.2020
(51) Int. Cl.: H04R 17/00, H04R 31/00, H04R 7/04

(54) **MEMS-SCHALLWANDLER MIT EINER AUS POLYMER AUSGEBILDETEN MEMBRAN**
MEMS TRANSDUCER HAVING A DIAPHRAGM MADE OF POLYMER
TRANSDUCTEUR ACOUSTIQUE DE TYPE MEMS MUNI D'UNE MEMBRANE FORMÉE DE POLYMÈRE

(30) Priorität: 13.06.2019 DE 102019116080
(43) Veröffentlichungstag der Anmeldung: 20.04.2022
(73) Patentinhaber: USound GmbH, 8020 Graz (AT)
(72) Erfinder: RUSCONI CLERICI BELTRAMI, Andrea, 1130 Wien (AT); BOTTONI, Ferruccio, 8020 Graz (AT); RENAUD-BEZOT, Nick, 1050 Wien (AT)
(74) Vertreter: Canzler & Bergmeier Patentanwälte Partnerschaft mbB
(86) Internationale Anmeldenummer: PCT/EP2020/065468
(87) Internationale Veröffentlichungsnummer: WO 2020/249457

(56) Entgegenhaltungen:
- EP-A2- 2 362 686
- DE-B3- 102017 200 111
- DE-T2- 60 313 715
- JP-A- 2011 077 919
- US-A1- 2016 337 759

## Beschreibung

Die vorliegende Erfindung betrifft ein Verfahren zum Herstellen eines MEMS-Schallwandlers zum Erzeugen und/oder Erfassen von Schallwellen im hörbaren Wellenlängenbereich und/oder im Ultraschallbereich, bei dem auf einem Trägersubstrat zumindest ein Piezoelement angeordnet wird und eine Membran auf dem zumindest einen Piezoelement ausgebildet wird.

Aus der DE 603 13 715 T2 ist ein Verfahren zum Herstellen eines MEMS-Wandlers bekannt. Dies erfolgt dadurch, dass eine Opferschicht auf ein Substrat aufgebracht wird. Danach wird aufeinanderfolgend eine Membranschicht, eine untere Elektrodenschicht, eine aktive Schicht und eine obere Elektrodenschicht aufgebracht.

In der JP 2011-077919 A ist ein Piezoelement von einem Harz umschlossen.

Aus der EP 2 362 686 A2 ist ein Schallwandler bekannt.

Aus der DE 10 2017 200 111 B3 ist ebenfalls eine Schallwandleranordnung bekannt.

In der US 2016/0337759 A1 ist ein Schallwandler offenbart.

Aufgabe der vorliegenden Erfindung ist es, den Stand der Technik zu verbessern.

Die Aufgabe wird gelöst durch ein Verfahren zum Herstellen eines MEMS-Schallwandlers und den MEMS-Schallwandler mit den Merkmalen der unabhängigen Patentansprüche.

Vorgeschlagen wird ein Verfahren zum Herstellen eines MEMS-Schallwandlers zum Erzeugen und/oder Erfassen von Schallwellen im hörbaren Wellenlängenbereich und/oder im Ultraschallbereich. Der MEMS-Schallwandler kann somit beispielsweise dazu benutzt werden, Musik, Töne und/oder Sprache als Lautsprecher zu erzeugen und/oder als Mikrofon aufzunehmen. Wenn Schallwellen im Ultraschallbereich erzeugt und/oder erfasst werden, können diese beispielsweise für technische Prüfgeräte oder in Ultraschallgeräten für Sonografie verwendet werden.

Bei dem Verfahren wird auf einem Trägersubstrat zumindest ein Piezoelement angeordnet. Auf dem Trägersubstrat ist somit das zumindest ein Piezoelement zum Erzeugen und/oder Erfassen der Schallwellen angeordnet. Das Piezoelement weist piezoelektrische Eigenschaften auf, so dass das Piezoelement ein elektrisches Signal bzw. eine elektrische Spannung in eine Verformung umwandeln kann, so dass dadurch die Schallwellen erzeugt werden können. Das Piezoelement kann aber auch Verformungen in ein elektrisches Signal bzw. eine elektrische Spannung umsetzen, so dass dadurch die Schallwellen erfasst werden können.

Des Weiteren wird eine Membran auf dem zumindest einen Piezoelement ausgebildet. Die Membran und das zumindest eine Piezoelement werden dadurch miteinander gekoppelt. Mittels der Kopplung können zum Erzeugen und/oder Erfassen der Schallwellen Schwingungen zwischen der Membran und dem zumindest einen Piezoelement ausgetauscht werden. Das Piezoelement kann beispielsweise zum Erzeugen der Schallwellen die Membran gemäß einem elektrischen Signal auslenken bzw. mit einer Schwingung beaufschlagen, so dass die Membran darüber angeordnete Luft ebenfalls zum Schwingen anregt, was die Schallwellen sind. Dagegen kann die durch die Schallwellen schwingende Luft die Membran ebenfalls zum Schwingen anregen, was wiederum auf das Piezoelement übertragen wird. Das Piezoelement setzt die Schwingungen in ein elektrisches Signal um.

Erfindungsgemäß wird das zumindest eine Piezoelement zur Ausbildung der Membran zumindest teilweise mit einem fließfähigen und aushärtbaren Polymer umgossen, welches nach dem Aushärten die Membran bildet. Das Polymer kann somit mittels eines Gießverfahrens eingegossen werden. Insbesondere wird die Membran mittels eines Gießverfahrens hergestellt. Das fließfähige Polymer passt sich somit, insbesondere von selbst, einer Kontur und/oder möglichen Unebenheiten an. Das Polymer kann beispielsweise eine derartige Viskosität aufweisen, dass es selbstständig das Piezoelement umfließt. Die Membran wird somit aus einem noch nicht ausgehärteten Polymer ausgebildet, so dass die Membran in einem einfachen Herstellungsschritt hergestellt werden kann. Das Polymer, welche die Membran bildet, ist somit noch flüssig und/oder fließfähig. Das zumindest eine Piezoelement kann auch von dem flüssigen bzw. fließfähigen Polymer eingegossen werden, was ebenfalls auf einfache Weise durchgeführt werden kann. Das Polymer umhüllt das zumindest eine Piezoelement zumindest teilweise. Die Membran ist somit dadurch mit dem zumindest einen Piezoelement gekoppelt, indem das Piezoelement von der Membran überzogen ist. Die Membran ist somit unmittelbar mit auf dem Piezoelement angeordnet und/oder unmittelbar mit dem Piezoelement verbunden. Das Polymer wird ferner um das Piezoelement gegossen, wenn dieses bereits auf dem Trägersubtrat angeordnet ist.

Vorteilhaft ist es, wenn das Trägersubstrat steif ist. Es weist insbesondere eine derart hohe Steifigkeit auf, dass das Trägersubstrat beim Betrieb des MEMS-Schallwandlers nicht oder lediglich unerheblich schwingt. Somit ist nicht das Trägersubstrat, sondern die auf das zumindest eine Piezoelement aufgegossene Membran zur Schallerzeugung und/oder zur Schallerfassung ausgebildet. Insbesondere ist die Steifigkeit des Trägersubstrats höher als die Steifigkeit der Membran nach dem Aushärten.
Insbesondere schwingt das zumindest eine Piezoelement und/oder die Membran gegenüber dem Trägersubstrat.

Ferner ist es von Vorteil, wenn zuerst das zumindest eine Piezoelement auf das Trägersubstrat angeordnet wird und anschließend das zumindest eine Piezoelement mit dem Polymer umgossen wird.

Die Membran weist vorteilhafterweise nach dem Aushärten des Polymers eine Flexibilität und/oder Elastizität auf.

Der Einfachheit halber kann anstatt von dem zumindest einen Piezoelement auch lediglich von dem Piezoelement gesprochen werden.

Des Weiteren kann der MEMS-Schallwandler zumindest ein Merkmal der nachfolgenden Beschreibung aufweisen. Insbesondere kann der MEMS-Schallwandler derart hergestellt werden, dass dieser zumindest ein Merkmal der nachfolgenden Beschreibung aufweist.

Die Membran weist nach dem Aushärten des Polymers, also das ausgehärtete Polymer, einen weiteren Vorteil auf. Die Membran aus dem ausgehärteten Polymer und das Piezoelement bilden einen Verbund. Das Piezoelement kann beispielsweise aus einer Keramik ausgebildet sein. Ferner ist es für das Schwingungsverhalten des Piezoelements besser, wenn das Piezoelement relativ dünn ist. Dadurch steigt jedoch die Gefahr, dass das Piezoelement bricht. Mit Hilfe der Membran aus dem ausgehärteten Polymer, welches auch nach dem Aushärten eine Elastizität und Flexibilität aufweist, kann das Piezoelement stabilisiert werden. Die Membran aus dem ausgehärteten Polymer und das Piezoelement bilden ein Verbundsystem, bei dem die Membran das Piezoelement stabilisiert.

Dadurch, dass die Membran zu Beginn des Herstellungsprozesses flüssig bzw. fließfähig ist, kann das Polymer das zumindest eine Piezoelement gut umschließen, umhüllen, überziehen, benetzen und/oder umfließen.

Das Polymer kann beispielsweise auf Silikonbasis basieren. Das Polymer kann ein organisches oder anorganisches Polymer sein. Das Polymer kann ein Kunststoff sein.

Vorteilhaft ist es, wenn zwischen dem Piezoelement und der Membran Adhäsion ausgebildet ist. Die Membran ist somit mittels einer Klebung mit dem Piezoelement verbunden.

Von Vorteil ist es, wenn das zumindest eine Piezoelement in einem Aufnahmeraum einer Dammanordnung angeordnet wird, so dass das Piezoelement von der Dammanordnung vollständig umrandet ist. Der Aufnahmeraum kann die Form eines Beckens bilden, welcher durch das Trägersubstrat, das zumindest eine Piezoelement und die Dammanordnung begrenzt ist. In den Aufnahmeraum bzw. das Becken kann während des Herstellungsverfahrens des MEMS-Schallwandlers das noch nicht ausgehärtete, also das flüssige bzw. fließfähige, Polymer eingefüllt bzw. eingegossen werden. Das Polymer in dem Becken bzw. dem Aufnahmeraum umschließt dann wenigstens das zumindest eine Piezoelement und bildet nach dem Aushärten die Membran. Die Dammanordnung und das zumindest eine Piezoelement sind dabei auf derselben Seite, einer Oberseite, des Trägersubstrats angeordnet. Die Dammanordnung kann ferner ein Rahmen sein, welcher vollständig um das zumindest eine Piezoelement angeordnet ist.

Dabei kann die Dammanordnung beispielsweise einteilig mit dem Trägersubstrat ausgebildet sein oder werden. Der MEMS-Schallwandler kann beispielsweise auf einem Wafer ausgebildet werden. Das Trägersubstrat kann dann ein Bereich des Wafers sein, wobei die Dammanordnung ebenfalls aus dem Wafer ausgebildet wird.

Zusätzlich oder alternativ kann die Dammanordnung auch auf dem Trägersubstrat angeordnet werden. Beispielsweise kann die Dammanordnung in einem separaten Verfahren hergestellt und dann auf dem Trägersubstrat angeordnet werden. Weiterhin zusätzlich oder alternativ kann die Dammanordnung auch unmittelbar auf dem Trägersubstrat ausgebildet werden. Die Dammanordnung kann beispielsweise mittels einem Abscheideverfahren auf dem Trägersubstrat ausgebildet werden.

Das Trägersubstrat und/oder die Dammanordnung können beispielsweise aus einem Siliziumwafer ausgebildet sein.

Außerdem kann zuerst der Aufnahmeraum ausgebildet werden und anschließend das Piezoelement in dem Aufnahmeraum angeordnet werden. Alternativ kann auch erst das Piezoelement auf dem Trägersubstrat angeordnet werden und anschließend der Aufnahmeraum ausgebildet werden.

Von Vorteil ist es, wenn das Polymer in den Aufnahmeraum gefüllt wird. Der Aufnahmeraum bildet somit einen Behälter für das Polymer. Das Polymer kann dabei in den Aufnahmeraum gefüllt werden, bis das zumindest eine Piezoelement vollständig mit dem Polymer bedeckt ist. Dadurch wird die Membran vollständig über dem Piezoelement ausgebildet.

Vorteilhaft ist es, wenn die Dammanordnung zumindest teilweise aus zumindest einer Dammeinheit ausgebildet wird. Als Dammanordnung können beispielsweise Elemente dienen, welche ohnehin auf dem Trägersubstrat angeordnet sind. Ein derartiges Element kann beispielsweise ein ASIC sein, welcher zur Steuerung des MEMS-Schallwandlers auf dem Trägersubstrat angeordnet ist. Mit Hilfe der zumindest einen Dammeinheit kann die Dammanordnung ausgebildet werden, so dass das Piezoelement vollständig umrandet wird. Der ASIC bildet damit einen Teilabschnitt der Dammanordnung.

Von Vorteil ist es, wenn die Dammanordnung zumindest teilweise einteilig mit dem Trägersubstrat ausgebildet wird. Das Trägersubstrat kann beispielsweise eine Leiterplatte sein. Die Dammanordnung kann somit auch aus dem Material, beispielsweise einem Kunststoff, ausgebildet sein. Die Dammanordnung kann somit zusammen mit dem Trägersubstrat ausgebildet werden. Dabei können auch die Dammeinheiten einteilig mit dem Trägersubstrat ausgebildet werden.

Zusätzlich oder alternativ kann die Dammanordnung zumindest teilweise mit dem Trägersubstrat verbunden werden. Dadurch kann die Dammanordnung, nachdem das Piezoelement auf dem Trägersubstrat angeordnet ist, auf das Trägersubstrat angeordnet werden, um auf die genaue Anordnung des zumindest einen Piezoelements eingehen zu können. Dabei kann die Dammanordnung beispielsweise mit dem Trägersubstrat verklebt werden. Zusätzlich oder alternativ kann auch das zumindest eine Piezoelement auf dem Trägersubstrat geklebt werden. Der Kleber, mit dem die Dammanordnung und/oder das Piezoelement auf dem Trägersubstrat angeordnet ist, kann beispielsweise elektrisch nicht leitfähig, d.h. isolierend, sein. Dabei kann auch die zumindest eine Dammeinheit mit dem Trägersubstrat verbunden bzw. auf die genannte Weise geklebt sein.

Vorteilhaft ist es, wenn der Aufnahmeraum vollständig mit dem Polymer befüllt wird. Dadurch kann sichergestellt werden, dass alle Elemente im Aufnahmeraum vom Polymer bedeckt und/oder umschlossen werden. Zusätzlich oder alternativ kann über der Dammanordnung angeordnetes Polymer abgestriffen und/oder abgezogen werden. Es kann vorkommen, insbesondere wenn der Aufnahmeraum vollständig mit Polymer befüllt wird, dass Polymer über die Dammanordnung ragt. Das überstehende Polymer kann dann beispielsweise mittels einer Abziehkante abgezogen und/oder abgestriffen werden. Dadurch wird das Polymer genau auf Höhe der Dammanordnung abgezogen. Die Dammanordnung und das Polymer sowie die anschließend gebildete Membran bilden somit eine bündige Ebene bzw. Fläche.

Von Vorteil ist es, wenn die Dammanordnung zusammen mit dem Trägersubstrat einteilig ausgebildet wird. Beispielsweise können Trägersubstrat und Dammanordnung mittels eines Abscheideverfahrens und/oder Ätzverfahrens ausgebildet werden.

Zusätzlich oder alternativ können die Dammanordnung und/oder das zumindest eine Piezoelement auf dem Trägersubstrat angeordnet werden. Dies kann beispielsweise mittels Kleben, Löten und/oder eutektischem bonden erfolgen. Beim Kleben kann ein elektrisch isolierender, also ein elektrisch nichtleitfähiger, Kleber benutzt werden.

Zusätzlich oder alternativ kann die Dammanordnung auch auf das Trägersubstrat aufgegossen werden.

Ferner werden auf das Trägersubstrat mehrere Piezoelemente angeordnet.

Die Piezoelemente weisen jeweils ein Fußelement und einen Kragarm auf, wobei der Kragarm an einem ersten Ende mit dem Fußelement verbunden ist und ein zweites Ende des Kragarms in Richtung einer Hubachse schwingen kann. Die Piezoelemente können derart auf dem Trägersubstrat angeordnet werden, dass sich deren zweite Enden in einem Zentrum treffen. Die Piezoelemente können somit konzentrisch angeordnet sein. Die Piezoelemente können symmetrisch oder asymmetrisch konzentrisch angeordnet sein.

Die Fußelemente können ferner gerade und/oder gebogen ausgebildet sein. Die Fußelemente können, wenn die Piezoelemente konzentrisch angeordnet sind, eine entsprechende Krümmung aufweisen, dass alle Fußelemente zusammen einen Kreis bilden. Alle Fußelemente können aber auch eine Ellipse bilden und sind dementsprechend gebogen bzw. gekrümmt.

Von Vorteil ist es, wenn die mehreren Piezoelemente als eine Piezoeinheit ausgebildet werden. Dabei können die Fußelemente einteilig miteinander ausgebildet werden, so dass die mehreren Piezoelemente zusammenhängen und die Piezoeinheit bilden. Dadurch können beim Herstellungsverfahren die mehreren Piezoelemente als Piezoeinheit in einem Schritt auf das Trägersubstrat angeordnet werden.

Zusätzlich oder alternativ können die Kragarme in einem Bereich an deren zweiten Enden, insbesondere im Zentrum, miteinander verbunden werden. Dadurch können die Kragarme als ein einziger Kragarm schwingen. Die Kragarme sind dadurch gekoppelt. Vorteilhafterweise werden die Kragarme derart ausgebildet, dass diese bereits an den zweiten Enden verbunden sind.

Von Vorteil ist es, wenn die mehreren Piezoelemente als Polygon angeordnet werden. Dabei können die Piezoelemente auch als Hexagon ausgebildet werden. Es sind somit sechs Piezoelemente auf dem Trägersubstrat. Der MEMS-Schallwandler umfasst somit sechs Piezoelemente.

Vorteilhaft ist es, wenn das zumindest eine Piezoelement mit zumindest einer Leitung mit einer Anschlussstelle auf dem Trägersubstrat verbunden wird. Wenn das Trägersubstrat eine Leiterplatte ist, kann diese die Anschlussstelle aufweisen, über die elektrische Signale zwischen dem Piezoelement und einer Steuereinheit ausgetauscht werden können. Es kann dabei jedes Piezoelement mit einer zugeordneten Leitung mit einer Anschlussstelle verbunden werden. Die Leitungen können ebenfalls von dem Polymer umgossen werden, so dass die Leitungen fixiert und/oder geschützt sind.

Von Vorteil ist es, wenn in dem Trägersubstrat Akustiköffnungen und/oder eine Durchgangsöffnung angeordnet werden. Mit Hilfe der Akustiköffnungen oder der zumindest einen Akustiköffnung können akustische Eigenschaften des MEMS-Schallwandlers angepasst werden.

Die Durchgangsöffnung kann in einem in Richtung Hubachse vom Zentrum beabstandeten Bereich angeordnet werden. In die Durchgangsöffnung können sich die Piezoelemente beim Schwingen hineinerstrecken. Die Piezoelemente stoßen dadurch nicht am Trägersubstrat an.

Von Vorteil ist es, wenn das zumindest eine Piezoelement und/oder die Dammanordnung, insbesondere von einer Montageeinheit, aufgenommen und auf das Trägersubstrat aufgesetzt wird. Dadurch wird das Herstellungsverfahren vereinfacht. Ferner kann mit Hilfe der Montageinheit das Piezoelement und/oder die Dammanordnung mit einer hohen Genauigkeit auf dem Trägersubstrat platziert werden.

Von Vorteil ist es, wenn auf dem Trägersubstrat mehrere MEMS-Schallwandler angeordnet werden, welche voneinander getrennt werden. Das Trägersubstrat kann ein Wafer sein, welcher bis zu 45 cm Durchmesser aufweisen kann. Darauf können mehrere MEMS-Schallwandler angeordnet werden, so dass in einem Herstellungsverfahren eine Vielzahl an MEMS-Schallwandlern ausgebildet werden. Dabei werden entsprechend viele Dammanordnungen und Piezoelemente auf dem Trägersubstrat angeordnet. Die Dammanordnung kann beispielsweise ein Gitter sein, das auf das Trägersubstrat angeordnet wird, wobei jedes Fenster des Gitters einen Aufnahmeraum bildet. Das Polymer kann dann flächig auf dem Trägersubstrat, beispielsweise den Wafer, gegossen werden, fließt in die Vielzahl an Aufnahmeräumen und umschließt die darin angeordneten Piezoelemente. In jedem Aufnahmeraum ist zumindest ein Piezoelement angeordnet. Das Polymer kann noch verstrichen bzw. verteilt und/oder abgezogen bzw. abgestreift werden.

Das Trägersubstrat, das zumindest eine Piezoelement sowie die Dammanordnung können schichtweise aufgebaut werden.

Auf das Trägersubstrat können auch mehrere MEMS-Schallwandler angeordnet werden. Die MEMS-Schallwandler können dann voneinander getrennt werden. Dazu kann das Trägersubstrat getrennt werden. Dadurch können in einem Herstellungsprozess mehrere MEMS-Schallwandler hergestellt werden.

Des Weiteren wird ein MEMS-Schallwandler zum Erzeugen und/oder Erfassen von Schallwellen im hörbaren Wellenlängenbereich und/oder im Ultraschallbereich vorgeschlagen.

Der MEMS-Schallwandler umfasst ein Trägersubstrat.

Ferner umfasst der MEMS-Schallwandler zumindest ein auf dem Trägersubrat angeordnetes Piezoelement zum Erzeugen und/oder Erfassen der Schallwellen.

Außerdem umfasst der MEMS-Schallwandler eine Membran, die mit dem zumindest einen Piezoelement gekoppelt ist, so dass zum Erzeugen und/oder Erfassen von Schallwellen Schwingungen zwischen der Membran und dem zumindest einen Piezoelement ausgetauscht werden können.

Erfindungsgemäß ist der MEMS-Schallwandler mittels zumindest einem Verfahrensmerkmal gemäß der vorangegangenen und/oder nachfolgenden Beschreibung ausgebildet.

Von Vorteil ist es, wenn das zumindest eine Piezoelement in einem Aufnahmeraum einer Dammanordnung angeordnet ist, welche das zumindest eine Piezoelement vollständig umrandet.

Zusätzlich oder alternativ kann die Dammanordnung zumindest teilweise aus zumindest einer Dammeinheit ausgebildet sein. Mit Hilfe der Dammeinheit kann die Dammanordnung nach Bedarf ausgebildet werden.

Zusätzlich oder alternativ kann die Dammanordnung, insbesondere die zumindest eine Dammeinheit, einteilig mit dem Trägersubstrat ausgebildet und/oder auf dem Trägersubstrat angeordnet sein.

Von Vorteil ist es, wenn das zumindest eine Piezoelement und die Dammanordnung in einer Querrichtung voneinander beabstandet sind. Die Querrichtung ist dabei quer zu einer Hubachse der Kragarme orientiert. Die Querrichtung ist ferner parallel zum Trägersubstrat orientiert. Durch den Abstand zwischen der Dammanordnung und dem Piezoelement kann zwischen diesen beiden das Polymer fließen. Dadurch können die Dammanordnung und das Piezoelement gegeneinander fixiert werden.

Vorteilhaft ist es, wenn die Dammanordnung eine Dammhöhe über dem Trägersubtrat aufweist, die höher bzw. größer ist als eine Piezoelementhöhe des zumindest einen Piezoelements über dem Trägersubstrat. Dadurch kann das noch nicht ausgehärtete Polymer in das durch die Dammanordnung gebildete Becken gefüllt werden. Das Becken kann das Polymer zumindest soweit aufnehmen, bis das zumindest eine Piezoelement vollständig bedeckt ist. Die Dammhöhe kann beispielsweise einen Betrag aufweisen, der der Piezoelementhöhe plus einer Dicke der Membran entspricht. Das noch nicht ausgehärtete Polymer kann dadurch in das Becken gefüllt werden und anschließend abgestrichen werden, so dass die Dammanordnung mit dem Polymer eine Ebene bildet. Dadurch wird exakt die Membran mit der gewünschten Dicke ausgebildet. Die Membran ist dann mit der Dammanordnung bündig.

Die Piezoelemente umfassen jeweils ein Fußelement und einen Kragarm, wobei der Kragarm mit einem ersten Ende mit dem Fußelement verbunden ist und ein vom Fußelement beabstandetes zweites Ende des Kragarms in Richtung einer Hubachse schwingen kann. Beim Anlegen der elektrischen Spannung bzw. des elektrischen Signals kann der Kragarm dabei entlang der Hubachse schwingen, so dass das Piezoelement und mittels der Membran die Schallwellen erzeugt werden kann. Der Kragarm kann auch selbst durch die Membran in Schwingungen versetzt werden, so dass dadurch die Schallwellen erfasst werden können. Die Piezoelemente sind ferner mittels dem zumindest einen Fußelement auf dem Trägersubstrat angeordnet. Dabei kann der Kragarm vollständig von der Membran überzogen sein.

Von Vorteil ist es, wenn zwischen dem zumindest einen Piezoelement und dem Trägersubstrat ein Hohlraum angeordnet ist, welcher von dem Trägersubtrat und dem Piezoelement, insbesondere vom Fußelement und/oder dem Kragarm, begrenzt ist. Der Hohlraum bildet einen Resonanzraum, mit welchem die akustischen Eigenschaften des MEMS-Schallwandlers verbessert werden können. Der Hohlraum ist auf der zur Membran gegenüberliegenden Seite des Piezoelements angeordnet. Ferner kann das zumindest eine Piezoelement in den Hohlraum schwingen. Der Hohlraum ist somit in Richtung der Hubachse unter dem Piezoelement angeordnet.

Der MEMS-Schallwandler umfasst mehrere Piezoelemente. Dadurch kann die Akustikleistung erhöht werden. Beispielsweise kann dadurch Musik mit einer höheren Leistung erzeugt werden. Wird der MEMS-Schallwandler dagegen als Mikrofon betrieben, können leisere Töne erfasst werden. Wenn mehrere Piezoelemente vorhanden sind, kann auch ein Teil als Lautsprecher und ein anderer Teil als Mikrofon betrieben werden.

Ferner ist es von Vorteil, wenn die mehreren Piezoelemente derart auf dem Trägersubstrat angeordnet sind, dass diese sich mit ihren jeweiligen zweiten Enden in einem Zentrum treffen. Dadurch können die mehreren Piezoelemente wie ein einziges, entsprechend größeres, Piezoelement wirken. Es kann einfacher sein, ein großes Piezoelement aus mehreren kleineren Piezoelementen zusammenzusetzen, als ein einziges großes Piezoelement herzustellen. Außerdem können die mehreren Piezoelemente zu verschiedenen Formen zusammengesetzt werden.

Vorteilhaft ist es, wenn die zweiten Enden der Piezoelemente miteinander im Zentrum verbunden sind. Dadurch können die mehreren Piezoelemente besser als ein einziges großes Piezoelement betrieben werden.

Von Vorteil ist es, wenn die mehreren Piezoelemente polygonförmig, insbesondere hexagonal, um das Zentrum angeordnet sind. Zusätzlich oder alternativ kann der Kragarm des zumindest einen Piezoelements dreieckig ausgebildet sein. Das erste Ende des Kragarms kann dabei die Grundseite des Dreiecks aufweisen bzw. bilden. Vorteilhafterweise ist am ersten Ende stets eine Grundseite des Polygons angeordnet, so dass das erste Ende mit dem Fußelement verbunden ist und dadurch eine flächige Verbindung zwischen Kragarm und Fußelement ausgebildet werden kann. An dem zweiten Ende des Kragarms kann dann die Spitze des Dreiecks angeordnet sein. Die Spitzen mehrerer Kragarme bzw. Dreiecke können sich somit im Zentrum treffen.

Vorteilhaft ist es, wenn der Kragarm des zumindest einen Piezoelements im Bereich des zweiten Endes einen Federabschnitt aufweist. Zusätzlich oder alternativ kann der Kragarm am zweiten Ende auch ein Federelement aufweisen.

Des Weiteren ist es zusätzlich oder alternativ von Vorteil, wenn die Kragarme mittels den Federabschnitten und/oder den Federelementen miteinander verbunden sind. Dabei kann auch nur ein Teil der Piezoelemente einen Federabschnitt und/oder ein Federelement aufweisen. Beispielsweise kann, wenn sich zwei Piezoelemente gegenüberliegen, lediglich ein Piezoelement einen Federabschnitt und/oder ein Federelement aufweisen. Mit Hilfe des Federabschnitts und/oder des Federelements können die Piezoelemente bewegt werden, auch wenn diese miteinander im Zentrum verbunden sind. Die Federabschnitte und/oder die Federelemente dehnen sich, wenn die Piezoelemente ausgelenkt werden bzw. schwingen.

Von Vorteil ist es, wenn die mehreren Piezoelemente konzentrisch zueinander angeordnet sind.

Ferner ist es vorteilhaft, wenn die jeweiligen Fußelemente der mehreren Piezoelemente einteilig miteinander ausgebildet sind. Infolgedessen sind die Piezoelemente miteinander verbunden und bilden somit eine Piezoeinheit aus mehreren Piezoelementen aus. Die Piezoeinheit kann dann als Bauteil auf das Trägersubstrat angeordnet werden.

Vorteilhaft ist es, wenn das Trägersubstrat eine Durchgangsöffnung aufweist, welche in Richtung der Hubachse unter dem Zentrum und/oder den Federabschnitten und/oder den Federelementen angeordnet ist. Dadurch kann sich das schwingbare zweite Ende des Kragarms des zumindest einen Piezoelements beim Schwingen in die Durchgangsöffnung hineinbewegen. Dadurch kann verhindert werden, dass der Kragarm beim Schwingen an dem Trägersubstrat anstößt.

Zusätzlich oder alternativ ist es von Vorteil, wenn das Trägersubstrat zumindest eine Akustiköffnung aufweist, welche im Bereich des Hohlraums angeordnet ist. Dadurch können die akustischen Eigenschaften des MEMS-Schallwandlers angepasst werden. Beispielsweise können dadurch Resonanzeigenschaften des Hohlraums angepasst werden.

Vorteilhaft ist es, wenn der Federabschnitt und/oder ein Bereich zwischen zwei benachbarten Piezoelementen derart ausgebildet ist, dass diese für das Polymer dicht sind. Die mehreren Piezoelemente und/oder der zumindest eine Federabschnitt weist somit eine Dichtigkeit für das Polymer auf. Dadurch kann verhindert werden, dass das noch nicht ausgehärtete Polymer in den Hohlraum fließen kann. Beispielsweise können die beiden benachbarten Piezoelemente einen derartigen Abstand zueinander aufweisen, dass das flüssige Polymer zurückgehalten wird. Der Abstand ist dabei abhängig von einer Viskosität des Polymers.

Von Vorteil ist es, wenn das Trägersubstrat als Leiterplatte ausgebildet ist. Das Trägersubstrat kann auch Anschlussstellen aufweisen. Dadurch kann mit Hilfe des Trägersubstrats das elektrische Signal bzw. die elektrische Spannung zum zumindest einen Piezoelement geführt und/oder von diesem weggeführt werden.

Zusätzlich oder alternativ kann das zumindest eine Piezoelement mit einer Leitung mit einer Anschlussstelle elektrisch verbunden sein. Dabei kann die Leitung in das Polymer eingegossen sein. Beim Herstellungsverfahren umfließt somit das flüssige Polymer auch die Leitung. Die Leitung kann dadurch vor Beschädigung geschützt werden.

Weitere Vorteile der Erfindung sind in den nachfolgenden Ausführungsbeispielen beschrieben. Es zeigen:
- **Figur 1**: eine perspektivische Schnittansicht eines schematischen MEMS-Schallwandlers mit einem auf einem Trägersubstrat angeordneten Piezoelement,
- **Figur 2**: eine Draufsicht auf den MEMS-Schallwandler mit sechs Piezoelementen,
- **Figur 3**: eine Schnittansicht des MEMS-Schallwandlers mit einer Membran und
- **Figur 4**: ein Flussdiagramm eines Verfahrens zum Herstellen des MEMS-Schallwandlers.

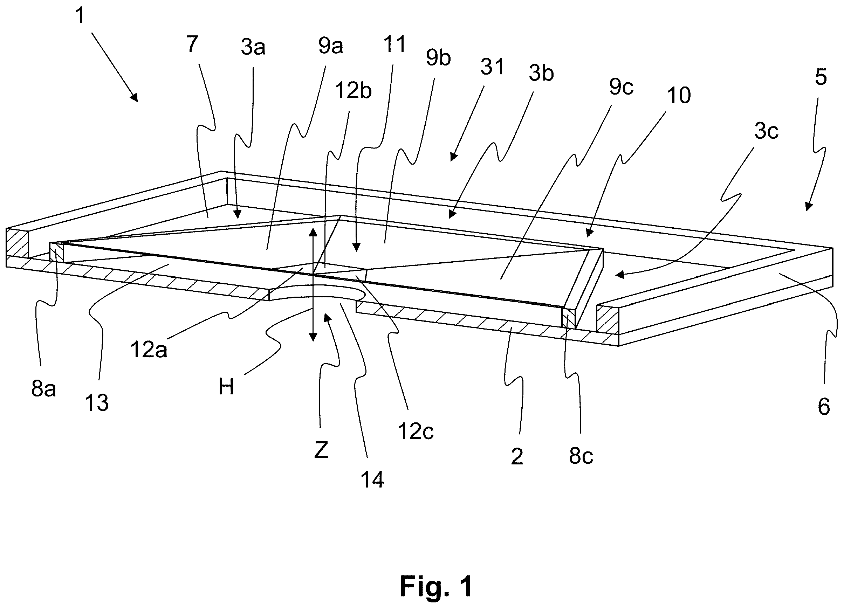

Figur 1 zeigt eine perspektivische Schnittansicht eines schematischen MEMS-Schallwandlers 1 mit mehreren auf einem Trägersubstrat 2 angeordneten Piezoelementen 3a - 3c. Der hier gezeigte MEMS-Schallwandler 1 ist dabei lediglich zur Hälfte gezeigt. Der Einfachheit halber kann im Folgenden lediglich von einem Piezoelement 3 gesprochen werden. Wenn es für die Beschreibung von Vorteil ist, kann von mehreren Piezoelementen 3a - 3c gesprochen werden. Der Übersichtlichkeit halber können auch Merkmale erst in einer folgenden Figur beschrieben und mit einem Bezugszeichen versehen sein.

Mit Hilfe des zumindest einen Piezoelements 3 können Schallwellen erfasst und/oder erzeugt werden. Mit Hilfe des zumindest einen Piezoelements 3 kann der MEMS-Schallwandler 1 somit als Lautsprecher und/oder als Mikrofon betrieben werden.

Das Piezoelement 3 ist mit einer hier nicht gezeigten Membran 4 gekoppelt (die Membran 4 ist erst in einer der folgenden Figuren gezeigt). Mit Hilfe der Membran 4 kann eine darüber angeordnete Luft in Schwingung versetzt werden, so dass die Schallwellen ausgebildet werden. Die Membran 4 wird in Schwingung versetzt, indem das Piezoelement 3 mit einem elektrischen Signal beaufschlagt wird, so dass sich das Piezoelement 3 gemäß dem Signal auslenkt. Dagegen kann die schwingende Luft die Membran 4 selbst zum Schwingen anregen, wobei das Piezoelement 3 mitschwingt. Das Piezoelement 3 setzt die eigenen Schwingungen in ein elektrisches Signal um, so dass die Schallwellen erfasst sind.

Die Membran 4 ist aus einem ausgehärteten Polymer 17 ausgebildet, mit welchem das zumindest eine Piezoelement 3 zumindest teilweise umgossen ist (das Polymer 17 ist ebenfalls in einer folgenden Figur gezeigt). Das Piezoelement 3 kann vom ausgehärteten Polymer 17 auch umgossen sein. Das Polymer 17 war somit beim Herstellungsprozess flüssig bzw. fließfähig und aushärtbar, so dass das Piezoelement 3 auf einfache Weise überzogen, insbesondere umgossen, werden kann. Nach dem Aushärten des Polymers 17 ist die Membran 4 gebildet.

Das ausgehärtete Polymer 17 weist auch nach Aushärten eine Flexibilität und Weichheit auf, so dass die darauf gebildete Membran 4 eine Elastizität aufweist. Die Elastizität der Membran 4 hängt dabei auch von ihrer Dicke D, insbesondere über dem in Figur 1 gezeigten Piezoelement 3, ab.

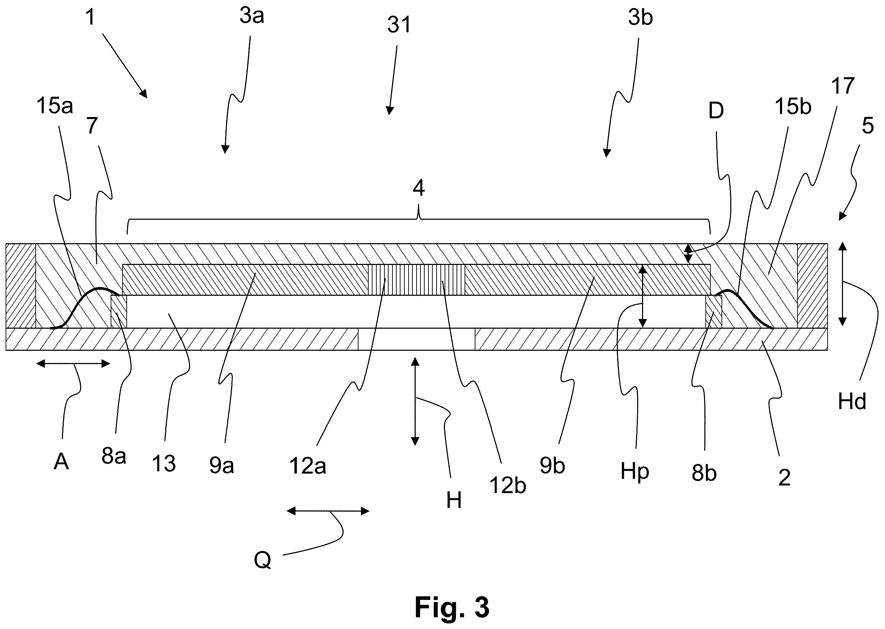

Die Dicke D der Membran 4 auf dem zumindest einem Piezoelement 3 kann beispielsweise zwischen 0,05 mm und 0,2 mm betragen. Die Dicke D der Membran 4 kann aber auch 0,1 mm betragen. Die Dicke der Membran 4 ist dabei in Richtung der Hubachse H gemessen. Die Dicke D der Membran 4 ist in Figur 3 mit einem Bezugszeichen versehen.

Die Membran 4 auf dem Piezoelement 3 bilden zusammen ein Verbundsystem. Das Piezoelement 3 aus einem Piezomaterial weist eine hohe Steifheit auf, so dass das Piezoelement 3 alleine bei Verformung brechen kann. Mit Hilfe des Überzugs aus dem ausgehärteten Polymers 17, welches zugleich die Membran 4 bildet und eine Elastizität aufweist. Die Membran 4 hält das Piezoelement 3 zusammen. Das Brechen des Piezoelements 3 kann dadurch verhindert werden.

Auf dem Trägersubstrat 2 ist in diesem Ausführungsbeispiel eine Dammanordnung 5 angeordnet. Die Dammanordnung 5 kann zusätzlich oder alternativ auch einteilig mit dem Trägersubstrat 2 ausgebildet sein bzw. werden. Die Dammanordnung 5 umrandet vorteilhafterweise das Piezoelement 3 vollständig. Durch die Dammanordnung 5 und das Trägersubstrat 2 ist ein Aufnahmeraum 7 gebildet. Beim Herstellungsverfahren kann in den Aufnahmeraum 7 das flüssige bzw. fließfähige Polymer 17 gefüllt werden, so dass das Piezoelement 3 von dem Polymer 17 umgossen bzw. umschlossen wird. Anschließend kann das Polymer 17 aushärten, wobei sich die Membran 4 bildet. Die Dammanordnung 5, das Trägersubtrat 2 und/oder das zumindest eine Piezoelement 3 bilden den Aufnahmeraum 7 oder ein Becken, in den das flüssige bzw. fließfähige Polymer 17 eingefüllt werden kann.

Die Dammanordnung 5 kann aus zumindest einer Dammeinheit 6 ausgebildet sein. Die Dammeinheit 6 und/oder die Dammanordnung 5 ist in diesem Ausführungsbeispiel als ein Rahmen ausgebildet, der das zumindest eine Piezoelement 3 umrandet. Die zumindest eine Dammeinheit 6 kann auch aus mehreren einzelnen Elementen ausgebildet sein, die derart auf dem Trägersubstrat 2 angeordnet sind/werden, so dass die Dammanordnung 5 das zumindest eine Piezoelement 3 vollständig umranden. Als Dammanordnung 5 können auch bereits vorhandene Elemente auf dem Trägersubstrat 2 dienen. Beispielsweise kann eine auf dem Trägersubtrat 2 angeordnete Steuereinheit, beispielsweise in Form eines ASICs, als Teil der Dammanordnung 5 dienen. Die Dammeinheit 6 kann dann derart ausgebildet sein, dass die Dammeinheit 6 und der ASIC die Dammanordnung 5 bilden.

Die Dammanordnung 5, insbesondere die hier gezeigte zumindest eine Dammeinheit 6, ist gemäß dem vorliegenden Ausführungsbeispiel mit dem Trägersubstrat 2 verbunden. Die Dammanordnung 5 kann beispielsweise auf das Trägersubstrat 2 aufgeklebt sein. Als Kleber kann beispielsweise ein elektrisch nicht leitfähiger, also ein elektrisch isolierender, Kleber verwendet werden. Alternativ kann die Dammanordnung 5 auch einteilig mit dem Trägersubstrat 2 ausgebildet sein. Dadurch kann beispielsweise der Herstellungsprozess des MEMS-Schallwandlers 1 vereinfacht werden.

Die Piezoelemente 3 weisen in dem hier gezeigten Ausführungsbeispiel jeweils ein Fußelement 8 und einen Kragarm 9 auf. Die hier gezeigten drei Piezoelemente 3a - 3c weisen jeweils ein Fußelement 8a - 8c und jeweils einen Kragarm 9a - 9c auf. Das Fußelement 8b ist hier nicht zu sehen. Es ist vom Kragarm 9b verdeckt. Der Einfachheit halber wird wieder lediglich von einem Fußelement 8 und einem Kragarm 9 gesprochen.

Der Kragarm 9 weist ein erstes Ende 10 und ein davon beabstandetes zweites Ende 11 auf. Der Übersichtlichkeit halber ist das erste und das zweite Ende 10, 11 lediglich am Kragarm 9c mit einem Bezugszeichen versehen. Die beiden Enden 10, 11 sind bei allen Piezoelementen 3 bzw. Kragarmen 9 gleich.

Der Kragarm 9 ist am ersten Ende 10 mit dem Fußelement 8 verbunden. Das zweite Ende 11 ist vom Fußelement 8 beabstandet. Der Kragarm 9 ist somit mit dem ersten Ende 10 am Fußelement 8 festgelegt. Das zweite Ende 11 kann gegenüber dem ersten Ende 10 frei schwingen. Das zweite Ende 11 kann in Richtung der Hubachse H schwingen.

Im vorliegenden Ausführungsbeispiel ist das zumindest eine Piezoelement 3 dreieckig ausgebildet. Hier sind alle Piezoelemente 3 dreieckig. Eine Grundseite des Dreiecks ist mit dem Fußelement 8 verbunden. Dadurch wird ein Verbindungsbereich zwischen Kragarm 9 und dem Fußelement 8 vergrößert. Eine Spitze des Dreiecks ist am zweiten Ende 11 angeordnet. Insbesondere treffen sich alle Spitzen aller Piezoelemente 3 im Zentrum Z. In der vorliegenden halben Schnittansicht sind drei dreieckige Piezoelemente 3 gezeigt. Der vollständige MEMS-Schallwandler 1 weist somit sechs dreieckige Piezoelemente 3 auf, welche derart angeordnet sind, dass sich ein, insbesondere regelmäßiges, Hexagon bildet.

Die zweiten Enden 11 der jeweiligen Kragarme 9 treffen sich in einem Zentrum Z. Gemäß dem vorliegenden Ausführungsbeispiel ist das Zentrum Z mittig zwischen den jeweiligen Piezoelementen 3 angeordnet. Die Piezoelemente 3, insbesondere die zweiten Enden 11 der jeweiligen Kragarme 9, können im Zentrum Z miteinander verbunden sein. Infolgedessen können die mehreren Piezoelemente 3 wie ein einziges, entsprechend größeres, Piezoelement 3 schwingen. Dadurch kann eine Leistung, insbesondere eine Lautsprecherleistung und/oder eine Mikrofonleistung, des MEMS-Schallwandlers 1 erhöht werden.

Das Piezoelement 3 weist im Bereich des zweiten Endes 11 des Kragarms 9 einen Federabschnitt 12 auf. Der Einfachheit halber wird wieder lediglich von einem Federabschnitt 12 gesprochen. Wenn es für die Erfindung nötig ist, wird von den Federabschnitten 12 gesprochen.

Die Federabschnitte 12a - 12c können sich dehnen, wenn die Piezoelemente 3 in Richtung der Hubachse H schwingen. Dadurch kann verhindert werden, dass die Piezoelemente 3 reißen oder brechen, wenn sie schwingen und im Zentrum Z miteinander verbunden sind.

Ferner können die Piezoelemente 3, insbesondere lediglich, mit den Federabschnitten 12 miteinander verbunden sein.

Der MEMS-Schallwandler 1 weist außerdem einen Hohlraum 13 auf. Der Hohlraum 13 ist in Richtung der Hubachse H zwischen dem zumindest einen Piezoelement 3 und dem Trägersubstrat 2 angeordnet. Der Hohlraum 13 ist auf der dem Aufnahmeraum 7 abgewandten Seite des zumindest einen Piezoelements 3 angeordnet. Das zumindest eine Piezoelement 3 trennt den Aufnahmeraum 7 vom Hohlraum 13. In den Hohlraum 13 kann das Piezoelement 3 schwingen. Der Hohlraum 13 kann ferner ein Resonanzraum sein. Der Hohlraum 13 ist in Richtung der Hubachse H unter dem Piezoelement 3 angeordnet. Das Piezoelement 3 kann somit in den Hohlraum 13 schwingen.

Des Weiteren ist im Trägersubstrat 2 des vorliegenden Ausführungsbeispiels eine Durchgangsöffnung 14 angeordnet. Hier ist die Durchgangsöffnung 14 in Richtung der Hubachse H unter dem Zentrum Z angeordnet. Die Durchgangsöffnung 14 kann eine Schallaustritts- und/oder Schalleintrittsöffnung sein. Zusätzlich oder alternativ können die zweiten Enden 11 in die Durchgangsöffnung 14 schwingen.

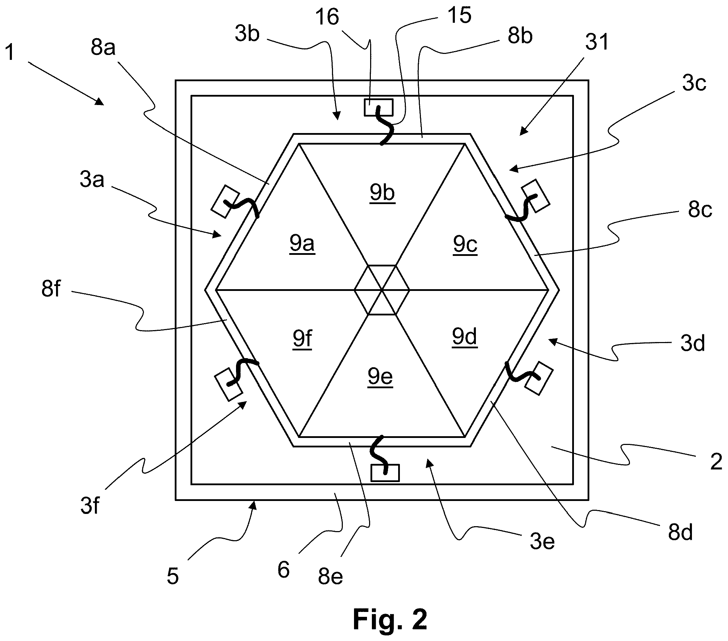

Figur 2 zeigt den MEMS-Schallwandler 1 mit sechs Piezoelementen 3a - 3f. Der Einfachheit halber werden Merkmale, die in der vorangegangenen Figur bereits beschrieben sind und welche im Wesentlichen die gleiche Wirkung aufweisen, hier nicht nochmals beschrieben. Außerdem werden für im Vergleich zur vorangegangenen Figur gleiche Merkmale mit gleichen Bezugszeichen versehen. Der Übersichtlichkeit halber können auch Merkmale erst in einer folgenden Figur beschrieben werden.

Gemäß dem hier gezeigten Ausführungsbeispiel sind die sechs Piezoelemente 3a - 3f in einem, insbesondere regelmäßigen, Hexagon angeordnet. Die Piezoelemente 3 können regelmäßig angeordnet sein, auch wenn weniger oder mehr als sechs Piezoelemente 3 auf dem Trägersubstrat 2 angeordnet sind. Beispielsweise können auch vier Piezoelemente 3 in einem Viereck oder acht Piezoelemente 3 in einem Achteck angeordnet sein.

Im vorliegenden Ausführungsbeispiel sind die Piezoelemente 3 als regelmäßige Dreiecke ausgebildet. Das heißt, jeder Winkel im Dreieck beträgt 60°.

Gemäß dem vorliegenden Ausführungsbeispiel ist jedes Piezoelement 3 mittels einer Leitung 15 mit einer Anschlussstelle 16 auf dem Trägersubstrat 2 elektrisch verbunden. Wenn das Trägersubstrat 2 als eine Leiterplatte ausgebildet ist, sind die Anschlussstellen 16 mit der Leiterplatte elektrisch verbunden bzw. sind Teil der Leiterplatte. Der Einfachheit und Übersichtlichkeit halber ist lediglich eine Leitung 15 und eine Anschlussstelle 16 mit einem Bezugszeichen versehen.

Des Weiteren sind gemäß dem vorliegenden Ausführungsbeispiel die Fußelemente 8a - 8f einteilig miteinander ausgebildet. Alternativ können auch zumindest ein Teil der Fußelemente 8a - 8f einzeln ausgebildet sein. Die Fußelemente 8a - 8f grenzen jedoch vorteilhafterweise aneinander an bzw. stoßen aneinander an, so dass das flüssige bzw. fließfähige Polymer 17 nicht zwischen den Fußelementen 8a - 8f hindurchfließen kann.

Figur 3 zeigt einen Schnitt des MEMS-Schallwandlers 1 mit Membran 4 aus ausgehärteten Polymer 17. Der Einfachheit halber werden Merkmale, die in der vorangegangenen Figur bereits beschrieben sind und welche im Wesentlichen die gleiche Wirkung aufweisen, hier nicht nochmals beschrieben. Außerdem werden für im Vergleich zu den vorangegangenen Figuren gleiche Merkmale mit gleichen Bezugszeichen versehen. Der Übersichtlichkeit halber können auch Merkmale erst in einer folgenden Figur beschrieben werden. Der Übersichtlichkeit halber ist der MEMS-Schallwandler 1 dicker ausgebildet, als er sein kann. Die Größenverhältnisse, insbesondere in Richtung der Hubachse H, sind zur besseren Erkennbarkeit vergrößert.

Gemäß dem vorliegenden Ausführungsbeispiel ist der Aufnahmeraum 7 mit dem Polymer 17 ausgefüllt. Das Polymer 17 kann auch die Leitungen 15a, 15b umschließen, so dass eine Beschädigung verhindert werden kann.

Das Polymer 17 ist ebenfalls auf dem zumindest einen Piezoelement 3 angeordnet, so dass es die Membran 4 bildet. Mit Hilfe der Membran 4 können die Schallwellen erfasst und/oder erzeugt werden. Die Membran 4 weist aber noch eine Elastizität auf und bildet mit dem Piezoelement 3 ein Verbundsystem, wobei die Membran 4 verhindert, dass das Piezoelement 3 bricht. Die Membran 4 ist dabei unmittelbar auf dem Piezoelement 3, insbesondere dem Kragarm 9, angeordnet. Beispielsweise kann zwischen der Membran 4 und dem Piezoelement 3, insbesondere dem Kragarm 9, Adhäsion ausgebildet sein. Diese entsteht, wenn das flüssige bzw. fließfähige Polymer 17 aushärtet. Das Polymer 17 bzw. die Membran 4 kann mit dem Piezoelement 3, insbesondere dem Kragarm 9, verklebt sein.

Des Weiteren ist das zumindest eine Piezoelement 3 dicht gegenüber dem flüssigen bzw. fließfähigen Polymer 17. Dadurch wird verhindert, dass das Polymer 17 in den Hohlraum 13 fließt. Wenn mehrere Piezoelemente 3 auf dem Trägersubstrat 2 angeordnet sind, weisen die Stellen, an denen die Piezoelemente 3 aneinander angrenzen die Dichtigkeit auf, so dass auch dort das Polymer 17 nicht in den Hohlraum 13 fließen kann.

Außerdem weist der Federabschnitt 12 eine Dichtigkeit auf, so dass das flüssige bzw. fließfähige Polymer nicht durch den Federabschnitt 12 fließen kann.

Die besagten Dichtigkeiten hängen natürlich von einer Viskosität des flüssigen bzw. fließfähigen Polymers 17 ab. Die Viskosität des Polymers 17 ist dabei derart, dass es sich selbstständig im Aufnahmeraum 7 verteilt und beispielsweise auch um die Leitungen 15 fließt.

Ferner weist die Dammanordnung 5, insbesondere die zumindest eine Dammeinheit 6, eine Dammhöhe Hd auf. Das zumindest eine Piezoelement 3 weist eine Piezoelementhöhe Hp auf. Vorteilhafterweise ist die Dammhöhe Hd größer als die Piezoelementhöhe Hp. Dadurch kann der Aufnahmeraum 7 vollständig mit dem Polymer 17 befüllt werden, so dass das Polymer 17 auch das zumindest eine Piezoelement 3, insbesondere den Kragarm 9, bedeckt und die Membran 4 ausbilden kann. Aus der Differenz zwischen Dammhöhe Hd und Piezoelementhöhe Hp kann sich die Dicke D der Membran 4 ergeben. Die Membran 4 ist dann bündig mit der Dammanordnung 5.

Die Dammhöhe Hd kann beispielsweise zwischen 0,3 mm und 2 mm liegen. Die Dammhöhe Hd kann auch 0,55 mm sein. Die Piezoelementhöhe Hp kann zwischen 0,2 und 1,5 mm liegen. Die Piezoelementhöhe Hp kann auch 0,45 mm sein. Eine hier nicht eingezeichnete Dicke des Trägersubstrats 2 kann 0,25 mm sein. Die Dicke des Trägersubstrats 2 kann aber auch zwischen 0,1 mm und 1,5 mm liegen.

Ferner weist der MEMS-Schallwandler 1 eine Querrichtung Q auf. Die Querrichtung Q ist quer zur Hubachse H orientiert. Die Querrichtung Q ist parallel zur Ebene des Trägersubstrats 2 orientiert.

Des Weiteren ist das zumindest eine Piezoelement 3 von der Dammanordnung 5 in Querrichtung Q beabstandet. Zwischen der Dammanordnung 5 und dem Piezoelement 3 ist ein Abstand A angeordnet.

Wie in Figur 3 gezeigt ist, ist der Abstand A zwischen der Dammanordnung 5 und den Piezoelementen 3 nicht konstant. Je nach Anordnung kann sich der Abstand A ändern.

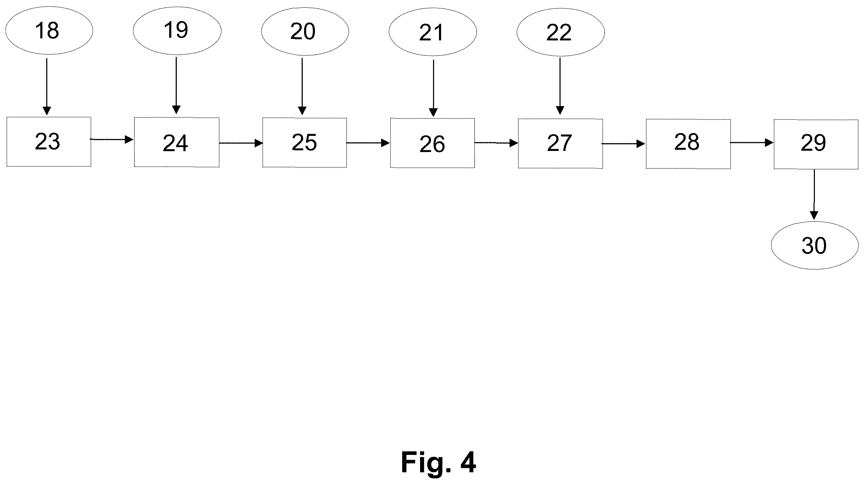

Figur 4 zeigt ein Flussdiagramm eines Verfahrens zum Herstellen des MEMS-Schallwandlers 1. Der MEMS-Schallwandler 1 kann dabei zumindest ein Merkmal der vorangegangenen Beschreibung, insbesondere der Figuren 1 - 3, aufweisen. Der MEMS-Schallwandler 1 kann ferner gemäß zumindest einem Merkmal der vorangegangenen Beschreibung, insbesondere der Figuren 1 - 3, ausgebildet werden. Insbesondere werden hier für die körperlichen Merkmale die Bezugszeichen der vorangegangenen Figuren verwendet. Der Einfachheit halber werden die Merkmale nicht nochmals erläutert, wenn diese die gleichen oder zumindest ähnlichen Eigenschaften aufweisen, wie in den vorangegangenen Figuren.

In einem ersten Schritt 18 kann das Trägersubstrat 2 bereitgesellt werden. Das Trägersubstrat 2 kann beispielsweise eine Leiterplatte sein, die entsprechend hergestellt ist. Das Trägersubstrat 2 kann auch ein Wafer sein, welcher mittels Abscheide- und/oder Ätzverfahren behandelt werden kann oder wird.

In einem folgenden Schritt 23 wird das Trägersubstrat 2 bestückt. Beispielsweise kann ein ASIC bzw. eine Steuereinheit auf das Trägersubstrat 2 angeordnet werden. Es können aber auch Leiterbahnen oder beispielsweise die Anschlussstellen 16 angeordnet werden.

In einem nächsten Schritt 19 wird ein Kleber bereitgestellt. Der Kleber kann beispielsweise ein elektrisch isolierender, d.h. ein nicht leitfähiger, Kleber sein. Mit Hilfe des Klebers können weitere Elemente, wie beispielsweise die Dammanordnung 5, die Dammeinheit 6 und/oder das Piezoelement 3, auf das Trägersubstrat 2 aufgeklebt werden.

In einem folgenden Schritt 24 wird der Kleber auf dem Trägersubstrat 2 verteilt bzw. angeordnet.

In einem hier nicht gezeigten und folgenden Schritt kann auch die Dammanordnung 5, insbesondere die zumindest eine Dammeinheit 6, auf das Trägersubstrat 2 angeordnet werden. Die Dammanordnung 5, insbesondere die zumindest eine Dammeinheit 6, kann dabei ebenfalls mittels des Klebers auf dem Trägersubstrat 2 angeordnet werden. Die Dammanordnung 5 kann jedoch auch erst in einem späteren Schritt auf das Trägersubstrat 2 angeordnet werden.

In einem nächsten Schritt 20 werden mehrere Piezoelemente 3 bereitgestellt. Die mehreren Piezoelemente 3 können auch zu einer Piezoeinheit 31 zusammengefasst und/oder miteinander verbunden sein. Dadurch können die mehreren Piezoelemente 3 als Piezoeinheit 31 auf dem Trägersubstrat 2 angeordnet werden.

In einem folgenden Schritt 25 werden die mehreren Piezoelemente 3 auf das Trägersubstrat 2 angeordnet. Dies kann mittels sogenanntem "pick and place" erfolgen. Es kann beispielsweise eine Montageeinheit, insbesondere ein Montageroboter, das zumindest eine Piezoelement 3 von einer Bevorratungseinheit greifen und auf das Trägersubstrat 2 setzen. Dabei können nacheinander und/oder gleichzeitig mehrere Piezoelemente 3 auf das Trägersubstrat 2 angeordnet werden. Dabei können die mehreren Piezoelemente 3 in Form eines Polygons, insbesondere eines Hexagons gemäß Figur 2, angeordnet werden. Es kann auch die Piezoeinheit 31 angeordnet werden. Die Dammanordnung 5 kann auch erst auf das Trägersubstrat 2 angeordnet werden, wenn das Piezoelement 3 bereits auf dem Trägersubstrat 2 angeordnet ist.

Die mehreren Piezoelemente 3 können auch zu einer Piezoeinheit 31 zusammengefasst sein. Beispielsweise können die Piezoelemente 3 zusammen hergestellt werden und zusammen die Piezoeinheit 31 bilden. Beispielsweise können die Fußelemente 8 der Piezoelemente 3 einteilig miteinander ausgebildet werden, so dass die Piezoelemente 3 zusammenhängen und die Piezoeinheit 31 bilden. Es wird dann die Piezoeinheit 31 auf das Trägersubstrat 2 angeordnet.

In einem hier nicht gezeigten Schritt kann, wenn alle Bauteile auf das Trägersubstrat 2 angeordnet sind, ein Aushärtungsschritt für den Kleber ausgeführt werden. Beispielsweise kann der Kleber mittels Wärmezufuhr ausgehärtet werden.

In einem folgenden Schritt 21 wird eine Leitung 15 bereitgestellt. Dabei werden natürlich mehrere Leitungen 15 bereitgestellt, wenn mehrere Piezoelemente 3 mit einer Leitung 15 versehen werden sollen. Ein Piezoelement 3 kann auch mit mehreren Leitungen 15 versehen werden.

In einem nächsten Schritt 26 wird die zumindest eine Leitung 15 mit dem zumindest einen Piezoelement 3 und/oder der Anschlussstelle 16 verbunden. Die Leitung 15 kann beispielsweise festgelötet werden.

In einem folgenden Schritt 22 wird das fließfähige bzw. flüssige Polymer 17 bereitgestellt. Das Polymer 17 kann beispielsweise in diesem Schritt 22 erst verflüssigt bzw. in einen fließfähigen Zustand gebracht werden. Beispielsweise kann das, zu Beginn feste, Polymer 17 erwärmt werden, so dass es fließfähig bzw. flüssig wird. Das Polymer 17 kann aber auch angemischt werden. Das Polymer 17 kann beispielsweise zumindest eine Zwei-Komponenten-Mischung sein, wobei eine Komponente ein Härter ist. Es können auch mehrere Komponenten gemischt werden. Vorzugsweise basiert das Polymer 17 auf einer Silikonbasis. Das Polymer 17 kann sich beispielsweise selbst aushärten, d.h. ohne äußeren Einfluss.

In einem nächsten Schritt 27 wird das fließfähige bzw. flüssige Polymer 17 um das zumindest eine Piezoelement 3 gegossen. Dabei kann das Polymer 17 über das Piezoelement 3 gegossen werden, bis es vollständig bedeckt ist. Einen Vorteil bringt es mit sich, wenn die Dammanordnung 5 auf dem Trägersubstrat 2 angeordnet ist. Mit der Dammanordnung 5 bildet sich der Aufnahmeraum 7 aus. Die Dammanordnung 5, das Trägersubstrat 2 und/oder das Piezoelement 3 bilden dann die Form eines Beckens aus. In den Aufnahmeraum 7 bzw. zwischen die Dammanordnung 5 kann das fließfähige Polymer 17 eingefüllt werden. Dadurch kann das Piezoelement 3 auf einfache Weise umgossen werden. Das Polymer 17 kann dabei soweit eingegossen werden, bis das Piezoelement 3 bedeckt ist. Alternativ kann der Aufnahmeraum 7 auch vollständig befüllt werden. Die Dammanordnung 5 ragt dabei über das Piezoelement 3 hinweg. Wie in Figur 3 gezeigt ist, kann die Dammhöhe Hd größer sein als die Piezoelementhöhe Hp. Vorteilhafterweise ist auch die Leitung 15 in dem Aufnahmeraum 7 angeordnet, so dass diese ebenfalls eingegossen werden.

In einem weiteren, hier nicht gezeigten, Schritt kann das Polymer 17, wenn es im Aufnahmeraum 7 und zwischen der Dammanordnung 5 angeordnet ist, abgestriffen werden. Beispielsweise bildet gemäß Figur 1 die Dammanordnung 5 eine Ebene, welche über dem Piezoelement 3 angeordnet ist. Mit einer Abziehkante kann so überschüssiges Polymer 17 abgezogen werden. Infolgedessen sind das Polymer 17 und die Dammanordnung 5 bündig zueinander (wie beispielsweise in Figur 3 gezeigt ist). Das Abziehen kann auch als Abstreifen bezeichnet werden.

In einem folgenden, hier nicht gezeigten, Schritt kann das Polymer 17 ausgehärtet werden, so dass sich die Membran 4 bildet. Das Polymer 17 kann dazu beispielsweise mit Wärme behandelt werden.

In einem darauffolgenden Schritt 28 können, wenn auf dem Trägersubstrat 2 mehrere MEMS-Schallwandler 1 angeordnet sind, die entsprechenden MEMS-Schallwandler 1 vereinzelt werden. Auf dem Trägersubstrat 2 können mehrere MEMS-Schallwandler 1 angeordnet werden, um in einem Verfahren mehrere MEMS-Schallwandler 1 auszubilden. Es können somit mehrere Dammanordnungen 5 auf dem Trägersubstrat 2 angeordnet werden, wobei in den Dammanordnungen 5 die Piezoelemente 3 angeordnet werden. Alternativ können auch erst die Vielzahl an Piezoelementen 3 auf dem Trägersubstrat 2 und im Anschluss die Dammanordnungen 5 angeordnet werden.

Wenn mehrere MEMS-Schallwandler 1 auf dem Trägersubstrat 2 angeordnet sind, kann das fließfähige Polymer 17 gleichzeitig in alle Aufnahmeräume 7 gefüllt werden. Daraufhin kann das Polymer 17 abgezogen und/oder abgestriffen werden, so dass in einem einzigen Verfahrensschritt mehrere Membranen 4 ausgebildet werden können.

In einem folgenden Schritt 29 kann der MEMS-Schallwandler 1 geprüft werden.

In einem darauffolgenden Schritt 20 kann der MEMS-Schallwandler 1 fertiggestellt werden. Er kann beispielsweise in einem Gehäuse verbaut werden.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: MEMS-Schallwandler
- 2: Trägersubstrat
- 3: Piezoelement
- 4: Membran
- 5: Dammanordnung
- 6: Dammeinheit
- 7: Aufnahmeraum
- 8: Fußelement
- 9: Kragarm
- 10: erstes Ende
- 11: zweites Ende
- 12: Federabschnitt
- 13: Hohlraum
- 14: Durchgangsöffnung
- 15: Leitung
- 16: Anschlussstelle
- 17: Polymer
- 18: Bereitstellen des Trägersubstrats
- 19: Bereitstellen des Klebers
- 20: Bereitstellen der Piezoeinheit
- 21: Bereitstellen der Leitung
- 22: Bereitstellen des Polymers
- 23: Bestückung des Trägersubstrats
- 24: Auftragen des Klebers
- 25: Anordnen des Piezoelements
- 26: Anordnen der Leitung
- 27: Vergießen des Polymers
- 28: Vereinzelung
- 29: Prüfen
- 30: Fertigstellung
- 31: Piezoeinheit

- H: Hubachse
- Z: Zentrum
- Hd: Dammhöhe
- Hp: Piezoelementhöhe
- D: Dicke
- Q: Querrichtung
- A: Abstand

## Patentansprüche

1. Verfahren zum Herstellen eines MEMS-Schallwandlers (1) zum Erzeugen und/oder Erfassen von Schallwellen im hörbaren Wellenlängenbereich und/oder im Ultraschallbereich,
bei dem auf einem Trägersubstrat (2) zumindest ein Piezoelement (3) angeordnet wird,
wobei eine Membran (4) auf dem zumindest einen Piezoelement (3) ausgebildet wird,
wobei auf das Trägersubstrat (2) mehrere Piezoelemente (3) angeordnet werden und
wobei die Piezoelemente (3) zur Ausbildung der Membran (4) zumindest teilweise mit einem fließfähigen und aushärtbaren Polymer (17) umgossen werden, welches nach dem Aushärten die Membran (4) bildet,
**dadurch gekennzeichnet,**
**dass** die Piezoelemente (3) jeweils ein Fußelement (8) und einen Kragarm (9) umfassen, wobei der Kragarm (9) mit einem ersten Ende (10) mit dem Fußelement (8) verbunden ist und ein vom Fußelement (8) beabstandetes zweites Ende (11) des Kragarms (9) in Richtung einer Hubachse (H) schwingen kann, wobei die Piezoelemente (3) mit dem zumindest einen Fußelement (8) auf dem Trägersubstrat (2) angeordnet werden.

2. Verfahren nach dem vorherigen Anspruch, **dadurch gekennzeichnet, dass** das zumindest eine Piezoelement (3) in einem Aufnahmeraum (7) einer Dammanordnung (5) angeordnet wird, so dass das Piezoelement (3) von der Dammanordnung (5) vollständig umrandet ist, und/oder dass das Polymer (17) in den Aufnahmeraum (7) gefüllt wird und/oder dass der Aufnahmeraum (7) vollständig mit dem Polymer (17) befüllt wird und/oder
dass über die Dammanordnung (5) angeordnetes Polymer (17) abgestreift und/oder abgezogen wird.

3. Verfahren nach dem vorherigen Anspruch, **dadurch gekennzeichnet, dass** die Dammanordnung (5) zusammen mit dem Trägersubstrat (2) einteilig ausgebildet wird und/oder
dass die Dammanordnung (5) auf dem Trägersubstrat (2) angeordnet wird und/oder
dass die Dammanordnung (5) auf das Trägersubstrat (2) aufgegossen wird.

4. Verfahren nach einem oder mehreren der vorherigen Ansprüche 1 - 3, **dadurch gekennzeichnet, dass** die Piezoelemente (3) derart auf dem Trägersubstrat (2) angeordnet werden, dass sich deren zweite Enden (11) in einem Zentrum (Z) treffen.

5. Verfahren nach dem vorherigen Anspruch 1, **dadurch gekennzeichnet, dass** die mehreren Piezoelemente (3) als eine Piezoeinheit (31) ausgebildet werden, wobei die Fußelemente (8) einteilig miteinander ausgebildet werden, und/oder
die Kragarme (9) in einem Bereich an deren zweiten Enden (11) miteinander verbunden werden.

6. Verfahren nach einem oder mehreren der vorherigen Ansprüche, **dadurch gekennzeichnet, dass** das zumindest eine Piezoelement (3) mit zumindest einer Leitung (15) mit einer Anschlussstelle (16) auf dem Trägersubstrat (2) verbunden wird.

7. Verfahren nach einem oder mehreren der vorherigen Ansprüche 1 - 6, **dadurch gekennzeichnet, dass** in dem Trägersubstrat (2) Akustiköffnungen und/oder eine Durchgangsöffnung (14) angeordnet werden.

8. MEMS-Schallwandler (1) zum Erzeugen und/oder Erfassen von Schallwellen im hörbaren Wellenlängenbereich und/oder im Ultraschallbereich
mit einem Trägersubstrat (2),
mit zumindest einem auf dem Trägersubrat (2) angeordneten Piezoelement (3) zum Erzeugen und/oder Erfassen der Schallwellen und mit einer Membran (4), die mit dem zumindest einen Piezoelement (3) gekoppelt ist, so dass zum Erzeugen und/oder Erfassen von Schallwellen Schwingungen zwischen der Membran (4) und dem zumindest einen Piezoelement (3) ausgetauscht werden können,
wobei MEMS-Schallwandler (1) mittels eines Verfahrens gemäß einem oder mehreren der vorherigen Ansprüche ausgebildet ist, so dass auf dem Trägersubstrat (2) mehrere Piezoelemente (3) angeordnet sind und so dass die Piezoelemente (3) zur Ausbildung der Membran (4) zumindest teilweise mit einem fließfähigen und aushärtbaren Polymer (17) umgossen sind, welches nach einem Aushärten die Membran (4) bildet,
**dadurch gekennzeichnet,**
**dass** die Piezoelemente (3) jeweils ein Fußelement (8) und einen Kragarm (9) umfassen, wobei der Kragarm (9) mit einem ersten Ende (10) mit dem Fußelement (8) verbunden ist und ein vom Fußelement (8) beabstandetes zweites Ende (11) des Kragarms (9) in Richtung einer Hubachse (H) schwingen kann, wobei die Piezoelemente (3) mit dem zumindest einen Fußelement (8) auf dem Trägersubstrat (2) angeordnet sind.

9. MEMS-Schallwandler nach dem vorherigen Anspruch, **dadurch gekennzeichnet, dass** das zumindest eine Piezoelement (3) in einem Aufnahmeraum (7) einer Dammanordnung (5) angeordnet ist, welche das zumindest eine Piezoelement (3) vollständig umrandet,
und/oder
dass die Dammanordnung (5) zumindest teilweise aus zumindest einer Dammeinheit (6) ausgebildet ist und/oder
dass die Dammanordnung (5) einteilig mit dem Trägersubstrat (2) ausgebildet und/oder auf dem Trägersubstrat (2) angeordnet ist.

10. MEMS-Schallwandler nach dem vorherigen Anspruch 9, **dadurch gekennzeichnet, dass** das zumindest eine Piezoelement (3) und die Dammanordnung in einer Querrichtung voneinander beabstandet sind und/oder dass die Dammanordnung (5) eine Dammhöhe (Hd) über dem Trägersubstrat (2) aufweist, die höher ist als eine Piezoelementhöhe (Hp) des zumindest einen Piezoelements (3) über dem Trägersubstrat (2).

11. MEMS-Schallwandler nach dem vorherigen Anspruch 8, **dadurch gekennzeichnet, dass** der Kragarm (9) des zumindest einen Piezoelements (3) im Bereich des zweiten Endes (11) einen Federabschnitt (12) und/oder ein Federelement aufweist und/oder
dass wenigstens zwei Kragarme (9) mittels den Federabschnitten (12) und/oder den Federelementen miteinander verbunden sind und/oder dass die Piezoelemente voneinander getrennt sind, wobei die Piezoelemente mittelbar über die Membran miteinander verbunden sind.

12. MEMS-Schallwandler dem vorherigen Anspruch 8, **dadurch gekennzeichnet, dass** die Fußelemente (8) der Piezoelemente (3) miteinander verbunden ausgebildet sind, so dass die Piezoelemente eine Piezoeinheit (31) ausbilden.

13. MEMS-Schallwandler nach dem vorherigen Anspruch 11, **dadurch gekennzeichnet, dass** der Federabschnitt (12) und/oder ein Bereich zwischen zwei benachbarten Piezoelementen (3) derart ausgebildet ist, dass diese für das fließfähige Polymer (17) dicht sind.

## Claims

1. A method for manufacturing a MEMS sound transducer (1) for generating and/or detecting sound waves in the audible wavelength range and/or in the ultrasonic range,
in which at least one piezo element (3) is arranged on a carrier substrate (2),
wherein a diaphragma (4) is formed on the at least one piezo element (3),
wherein multiple piezo elements (3) are arranged on the carrier substrate (2), and
wherein the piezo elements (3) for forming the diaphragma (4) are at least partially encapsulated with a flowable and curable polymer (17) which forms the diaphragma (4) after curing,
**characterized in that**
the piezo elements (3) each comprise a base element (8) and a cantilever arm (9), wherein the cantilever arm (9) is connected with a first end (10) to the base element (8) and a second end (11) of the cantilever arm (9) spaced apart from the base element (8) can oscillate in the direction of a reciprocation axis (H), wherein the piezo elements (3) are arranged with the at least one base element (8) on the carrier substrate (2).

2. The method according to the preceding claim, **characterized in that** the at least one piezo element (3) is arranged in an accommodation space (7) of a dam arrangement (5) so that the piezo element (3) is completely enclosed by the dam arrangement (5), and/or **in that** the polymer (17) is filled into the accommodation space (7) and/or **in that** the accommodation space (7) is completely filled with the polymer (17), and/or
**in that** the polymer (17) arranged over the dam arrangement (5) is stripped off and/or pulled off.

3. The method according to the preceding claim, **characterized in that** the dam arrangement (5) is formed in one piece together with the carrier substrate (2), and/or
**in that** the dam arrangement (5) is arranged on the carrier substrate (2), and/or
**in that** the dam arrangement (5) is cast onto the carrier substrate (2).

4. The method according to one or more of the preceding claims 1-3, **characterized in that** the piezo elements (3) are arranged on the carrier substrate (2) in such a way that their second ends (11) meet in a center (Z).

5. The method according to the preceding claim 1, **characterized in that** the multiple piezo elements (3) are formed as a piezo unit (31),
wherein the base elements (8) are formed in one piece with one another, and/or
the cantilever arms (9) are connected to one another in a region at their second ends (11).

6. The method according to one or more of the preceding claims, **characterized in that** the at least one piezo element (3) is connected with at least one line (15) to a connection point (16) on the carrier substrate (2).

7. The method according to one or more of the preceding claims 1-6, **characterized in that** acoustic openings and/or a through-opening (14) are arranged in the carrier substrate (2).

8. A MEMS sound transducer (1) for generating and/or detecting sound waves in the audible wavelength range and/or in the ultrasonic range comprising a carrier substrate (2),
comprising at least one piezo element (3) arranged on the carrier substrate (2) for generating and/or detecting the sound waves and comprising a diaphragma (4) which is coupled to the at least one piezo element (3), so that oscillations between the diaphragma (4) and the at least one piezo element (3) can be exchanged for generating and/or detecting sound waves, wherein the MEMS sound transducer (1) is formed by means of a method according to one or more of the preceding claims, so that multiple piezo elements (3) are arranged on the carrier substrate (2) and so that the piezo elements (3) for forming the diaphragma (4) are at least partially encapsulated with a flowable and curable polymer (17) which forms the diaphragma (4) after curing,
**characterized in that**
the piezo elements (3) each comprise a base element (8) and a cantilever arm (9), wherein the cantilever arm (9) is connected with a first end (10) to the base element (8) and a second end (11) of the cantilever arm (9) spaced apart from the base element (8) can oscillate in the direction of a reciprocation axis (H), wherein the piezo elements (3) are arranged with the at least one base element (8) on the carrier substrate (2).

9. The MEMS sound transducer according to the preceding claim, **characterized in that** the at least one piezo element (3) is arranged in an accommodation space (7) of a dam arrangement (5) which completely encloses the at least one piezo element (3), and/or
**in that** the dam arrangement (5) is at least partially formed from at least one dam unit (6), and/or
**in that** the dam arrangement (5) is formed in one piece with the carrier substrate (2) and/or is arranged on the carrier substrate (2).

10. The MEMS sound transducer according to the preceding claim 9, **characterized in that** the at least one piezo element (3) and the dam arrangement are spaced apart from each other in a transverse direction, and/or **in that** the dam arrangement (5) has a dam height (Hd) above the carrier substrate (2) which is higher than a piezo element height (Hp) of the at least one piezo element (3) above the carrier substrate (2).

11. The MEMS sound transducer according to the preceding claim 8, **characterized in that** the cantilever arm (9) of the at least one piezo element (3) has a spring section (12) and/or a spring element in the region of the second end (11), and/or
**in that** at least two cantilever arms (9) are connected to one another by means of the spring sections (12) and/or the spring elements, and/or
**in that** the piezo elements are separated from one another, wherein the piezo elements are indirectly connected to one another via the diaphragma.

12. The MEMS sound transducer according to the preceding claim 8, **characterized in that** the base elements (8) of the piezo elements (3) are formed connected to one another, so that the piezo elements form a piezo unit (31).

13. The MEMS sound transducer according to the preceding claim 11, **characterized in that** the spring section (12) and/or a region between two adjacent piezo elements (3) is formed in such a way that they are tight for the flowable polymer (17).

## Revendications

1. Procédé pour fabriquer un transducteur acoustique MEMS (1) pour générer et/ou détecter des ondes acoustiques dans la plage de longueurs d'onde audibles et/ou dans la plage des ultrasons,
dans lequel au moins un élément piézoélectrique (3) est disposé sur un substrat de support (2),
dans lequel une membrane (4) est formée sur l'au moins un élément piézoélectrique (3),
dans lequel plusieurs éléments piézoélectriques (3) sont disposés sur le substrat de support (2) et
dans lequel les éléments piézoélectriques (3) pour former la membrane (4) sont enrobés au moins en partie avec un polymère (17) fluide et durcissable, qui forme la membrane (4) après durcir,
**caractérisé en ce que**
les éléments piézoélectriques (3) comprennent à chaque fois un élément de base (8) et un bras en porte-à-faux (9), dans lequel le bras en porte-à-faux (9) est connecté par une première extrémité (10) à l'élément de base (8) et une deuxième extrémité (11) du bras en porte-à-faux (9) espacée de l'élément de base (8) peut osciller dans la direction d'un axe de levage (H), dans lequel les éléments piézoélectriques (3) sont disposés avec l'au moins un élément de base (8) sur le substrat de support (2).

2. Procédé selon la revendication précédente, **caractérisé en ce que** l'au moins un élément piézoélectrique (3) est disposé dans un espace de réception (7) d'un agencement de barrage (5), de sorte que l'élément piézoélectrique (3) est entièrement entouré par l'agencement de barrage (5), et/ou **en ce que** le polymère (17) est rempli dans l'espace de réception (7) et/ou **en ce que** l'espace de réception (7) est entièrement rempli avec le polymère (17) et/ou
**en ce que** le polymère (17) disposé sur l'agencement de barrage (5) est raclé et/ou retiré.

3. Procédé selon la revendication précédente, **caractérisé en ce que** l'agencement de barrage (5) est réalisé d'une seule pièce conjointement avec le substrat de support (2) et/ou
**en ce que** l'agencement de barrage (5) est disposé sur le substrat de support (2) et/ou
**en ce que** l'agencement de barrage (5) est coulé sur le substrat de support (2).

4. Procédé selon l'une ou plusieurs des revendications précédentes 1 à 3, **caractérisé en ce que** les éléments piézoélectriques (3) sont disposés sur le substrat de support (2) de telle sorte que leurs deuxièmes extrémités (11) se rencontrent en un centre (Z).

5. Procédé selon la revendication précédente 1, **caractérisé en ce que** les plusieurs éléments piézoélectriques (3) sont réalisés sous la forme d'une unité piézoélectrique (31), dans lequel les éléments de base (8) sont réalisés d'une seule pièce les uns avec les autres, et/ou
les bras en porte-à-faux (9) sont connectés les uns aux autres dans une zone au niveau de leurs deuxièmes extrémités (11).

6. Procédé selon l'une ou plusieurs des revendications précédentes, **caractérisé en ce que** l'au moins un élément piézoélectrique (3) est connecté par au moins une ligne (15) à un point de connexion (16) sur le substrat de support (2).

7. Procédé selon l'une ou plusieurs des revendications précédentes 1 à 6, **caractérisé en ce que** des ouvertures acoustiques et/ou une ouverture de passage (14) sont disposées dans le substrat de support (2).

8. Transducteur acoustique MEMS (1) pour générer et/ou détecter des ondes acoustiques dans la plage de longueurs d'onde audibles et/ou dans la plage des ultrasons,
comprenant un substrat de support (2),
comprenant au moins un élément piézoélectrique (3) disposé sur le substrat de support (2) pour générer et/ou détecter les ondes acoustiques et
comprenant une membrane (4), qui est couplée à l'au moins un élément piézoélectrique (3), de sorte que des oscillations peuvent être échangées entre la membrane (4) et l'au moins un élément piézoélectrique (3) pour générer et/ou détecter des ondes acoustiques, dans lequel le transducteur acoustique MEMS (1) est formé au moyen d'un procédé selon l'une ou plusieurs des revendications précédentes, de sorte que plusieurs éléments piézoélectriques (3) sont disposés sur le substrat de support (2) et de sorte que les éléments piézoélectriques (3) pour former la membrane (4) sont enrobés au moins en partie avec un polymère (17) fluide et durcissable, qui forme la membrane (4) après un durcissement,
**caractérisé en ce que**
les éléments piézoélectriques (3) comprennent à chaque fois un élément de base (8) et un bras en porte-à-faux (9), dans lequel le bras en porte-à-faux (9) est connecté par une première extrémité (10) à l'élément de base (8) et une deuxième extrémité (11) du bras en porte-à-faux (9) espacée de l'élément de base (8) peut osciller dans la direction d'un axe de levage (H), dans lequel les éléments piézoélectriques (3) sont disposés avec l'au moins un élément de base (8) sur le substrat de support (2).

9. Transducteur acoustique MEMS selon la revendication précédente, **caractérisé en ce que** l'au moins un élément piézoélectrique (3) est disposé dans un espace de réception (7) d'un agencement de barrage (5), qui entoure entièrement l'au moins un élément piézoélectrique (3), et/ou
**en ce que** l'agencement de barrage (5) est formé au moins en partie à partir d'au moins une unité de barrage (6) et/ou
**en ce que** l'agencement de barrage (5) est réalisé d'une seule pièce avec le substrat de support (2) et/ou est disposé sur le substrat de support (2).

10. Transducteur acoustique MEMS selon la revendication précédente 9, **caractérisé en ce que** l'au moins un élément piézoélectrique (3) et l'agencement de barrage sont espacés l'un de l'autre dans une direction transversale et/ou **en ce que** l'agencement de barrage (5) comporte une hauteur de barrage (Hd) au-dessus du substrat de support (2), qui est supérieure à une hauteur d'élément piézoélectrique (Hp) de l'au moins un élément piézoélectrique (3) au-dessus du substrat de support (2).

11. Transducteur acoustique MEMS selon la revendication précédente 8, **caractérisé en ce que** le bras en porte-à-faux (9) de l'au moins un élément piézoélectrique (3) comporte dans la zone de la deuxième extrémité (11) une section de ressort (12) et/ou un élément de ressort et/ou en ce qu'au moins deux bras en porte-à-faux (9) sont connectés les uns aux autres au moyen des sections de ressort (12) et/ou des éléments de ressort et/ou
**en ce que** les éléments piézoélectriques sont séparés les uns des autres, dans lequel les éléments piézoélectriques sont connectés les uns aux autres indirectement par le biais de la membrane.

12. Transducteur acoustique MEMS selon la revendication précédente 8, **caractérisé en ce que** les éléments de base (8) des éléments piézoélectriques (3) sont réalisés de manière connectée les uns aux autres, de sorte que les éléments piézoélectriques forment une unité piézoélectrique (31).

13. Transducteur acoustique MEMS selon la revendication précédente 11, **caractérisé en ce que** la section de ressort (12) et/ou une zone entre deux éléments piézoélectriques (3) adjacents est réalisée de telle sorte que ceux-ci sont étanches pour le polymère (17) fluide.
